(19)

**Europäisches Patentamt**
**European Patent Office**
**Office européen des brevets**

(11) **EP 1 417 720 B1**

(12) **EUROPÄISCHE PATENTSCHRIFT**

(45) Veröffentlichungstag und Bekanntmachung des Hinweises auf die Patenterteilung:
**11.02.2015 Patentblatt 2015/07**

(21) Anmeldenummer: **02740389.8**

(22) Anmeldetag: **05.06.2002**

(51) Int Cl.:
***H01L 33/20*** *(2010.01)*

(86) Internationale Anmeldenummer:
**PCT/DE2002/002047**

(87) Internationale Veröffentlichungsnummer:
**WO 2003/017385 (27.02.2003 Gazette 2003/09)**

(54) **STRAHLUNGSEMITTIERENDER CHIP UND STRAHLUNGSEMITTIERENDES BAUELEMENT**

RADIATION-EMITTING CHIP AND RADIATION-EMITTING COMPONENT

PUCE EMETTANT UN RAYONNEMENT ET COMPOSANT EMETTANT UN RAYONNEMENT

(84) Benannte Vertragsstaaten:
**DE FR GB**

(30) Priorität: **13.08.2001 DE 10139723**

(43) Veröffentlichungstag der Anmeldung:
**12.05.2004 Patentblatt 2004/20**

(73) Patentinhaber: **OSRAM Opto Semiconductors GmbH**
**93055 Regensburg (DE)**

(72) Erfinder:
- **BAUR, Johannes**
**93180 Deuerling (DE)**
- **EISERT, Dominik**
**93049 Regensburg (DE)**
- **HÄRLE, Volker**
**93164 Waldetzenberg (DE)**

(74) Vertreter: **Epping - Hermann - Fischer Patentanwaltsgesellschaft mbH Schloßschmidstraße 5 80639 München (DE)**

(56) Entgegenhaltungen:
EP-A- 0 405 757      EP-A- 0 961 328
WO-A-02/073705      WO-A1-02/03477
JP-A- 08 288 577      US-A- 5 864 171
US-A- 5 929 465

- **PATENT ABSTRACTS OF JAPAN vol. 1999, no. 03, 31. März 1999 (1999-03-31) -& JP 10 326910 A (LEE SONG-JAE), 8. Dezember 1998 (1998-12-08)**
- **PATENT ABSTRACTS OF JAPAN vol. 008, no. 084 (E-239), 18. April 1984 (1984-04-18) & JP 59 004088 A (TOSHIBA CORP), 10. Januar 1984 (1984-01-10)**
- **BHARGAVA R.: "Blue and UV LEDs and lasers", OPTOELECTRONICS - DEVICES AND TECHNOLOGIES, vol. 7, 1992, pages 19-47, XP000294313,**

**Beschreibung**

Die Erfindung betrifft einen strahlungsemittierenden Chip nach dem Oberbegriff des Patentanspruches 1 und ein strahlungsemittierendes Bauelement nach dem Oberbegriff des Patentanspruches 15.

Ein strahlungsemittierender Chip der genannten Art weist in der Regel eine Mehrschichtstruktur mit einer aktiven strahlungserzeugenden Schicht auf, die auf ein Substrat aufgebracht ist. Die Strahlungsauskoppelung erfolgt zumindest teilweise durch das Substrat hindurch, wobei das Substrat für die erzeugte Strahlung transparent ist.

Die Strahlungsausbeute wird bei dieser Anordnung durch Totalreflexion an der Substratoberfläche oftmals stark eingeschränkt. Diese Problematik tritt besonders bei Substraten mit einem hohen Brechungsindex, beispielsweise einem SiC-Substrat, und einem dementsprechend kleinen Totalreflexionswinkel auf.

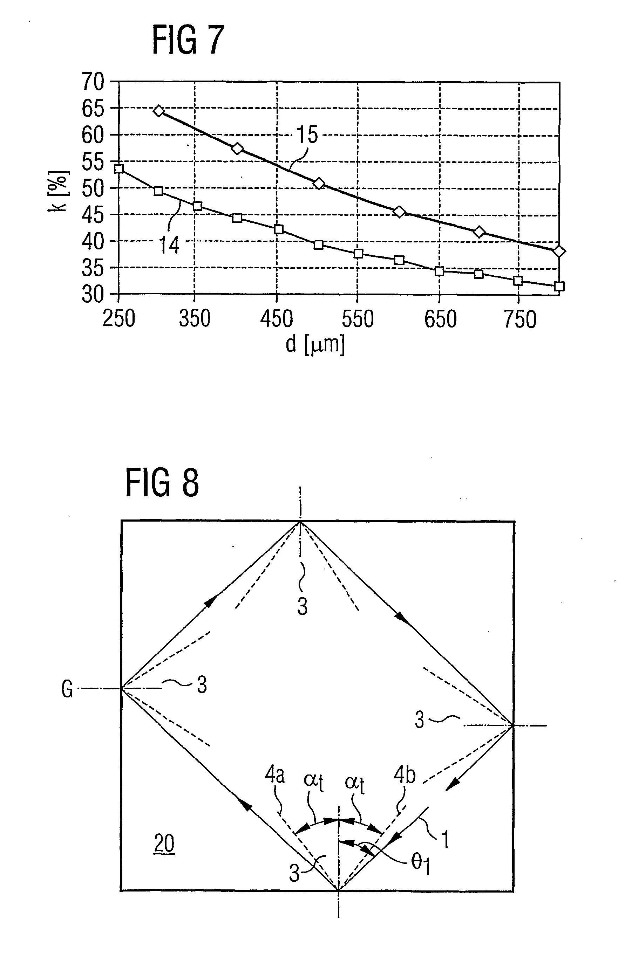

In besonderem Maße ist dies bei einem Substrat mit einem quadratischen oder rechteckigen Querschnitt der Fall, bei dem mehrfache, aufeinanderfolgende Totalreflexionen die Strahlungsausbeute begrenzen. Dies ist beispielhaft in Figur 8 dargestellt. Gezeigt ist hier ein Schnitt durch ein strahlungsdurchlässiges Substrat 20. Trifft ein in der Schnittebene propagierender Strahlungsanteil 1 auf eine Grenzfläche des Substrats 20 auf, so wird er zumindest teilweise ausgekoppelt, wenn der Einfallswinkel $\theta_1$ kleiner als der Totalreflexionswinkel $\alpha_t$ ist. Einfallswinkel und Totalreflexionswinkel beziehen sich hier und im folgenden auf die Grenzflächennormale.

Ist der Einfallswinkel $\theta_1$ wie dargestellt größer als der Totalreflexionswinkel $\alpha_t$, so wird der betreffende Strahlunbgsanteil 1 totalreflektiert. Durch den Totalreflexionswinkel $\alpha_t$ ist somit ein sogenannter Auskopplungskegel 3, im Schnitt dargestellt durch die gestrichelten Begrenzungen 4a, 4b, festgelegt, dessen Öffnungswinkel $2\alpha_t$ beträgt. Trifft der betreffende Strahlungsanteil 1 so auf die Grenzfläche, daß er innerhalb des Auskopplungskegels 3 liegt, so wird er zumindest teilweise ausgekoppelt, andernfalls totalreflektiert.

Im dargestellten Beispiel weist das Substrat 20 einen quadratischen Querschnitt auf. Der Strahlungsanteil 1 trifft fortlaufend außerhalb des Auskopplungskegels 3 auf die Grenzflächen des Substrats 20. Der Strahlungsanteil 1 läuft daher unter mehrfacher Totalreflexion zyklisch im Substrat 20 um und wird schließlich absorbiert, ohne vorher ausgekoppelt zu werden.

Die Druckschrift JP 10-326910 A offenbart eine lichtemittierende Diode, bei der der Halbleiterchip einen dreieckförmigen Querschnitt mit schräg verlaufenden Seitenflächen aufweist. Die Druckschrift EP 0961328 A2 offenbart einen strahlungsemittierenden Chip auf GaN-Basis, der gemäß einem Ausführungsbeispiel einen Querschnitt in Form eines gleichseitigen Dreiecks aufweist. Weiterhin offenbart auch die Druckschrift JP 08-288577 A einen strahlungsemittierenden Halbleiterchip mit einer dreieckförmigen Querschnittsfläche.

Aufgabe der vorliegenden Erfindung ist es, einen strahlungsemittierenden Chip mit verbesserter Strahlungsauskopplung zu schaffen. Weiterhin ist es Aufgabe der Erfindung, ein strahlungsemittierendes Bauelement mit verbesserter Strahlungsausbeute anzugeben.

Diese Aufgabe wird durch einen Chip gemäß Patentanspruch 1 bzw. ein Bauelement gemäß Patentanspruch 15 gelöst. Vorteilhafte Weiterbildungen der Erfindung sind Gegenstand der abhängigen Ansprüche.

Erfindungsgemäß ist vorgesehen, einen strahlungsemittierenden Halbleiterchip mit einem strahlungsdurchlässigen, einen Brechungsindex $n_F$ und eine Hauptfläche aufweisenden Fenster und einer Mehrschichtstruktur aus Halbleiterschichten, die eine strahlungserzeugende aktive Schicht umfaßt und an der Hauptfläche des Fensters angeordnet ist, zu bilden, wobei das Fenster von einem Medium mit einem Brechungsindex $n_0$, der kleiner als der Brechungsindex des Fensters $n_F$ ist, umgeben ist, wobei $n_F/n_0 < 2$ gilt. Das Fenster weist mindestens zwei Begrenzungsflächen auf, die einen Winkel $\beta$ einschließen, für den die Doppelungleichung

$$90° - \alpha_t < \beta < 2\,\alpha_t$$

erfüllt ist. Diese Ungleichung wird im folgenden als Auskoppelbedingung bezeichnet. $\alpha_t$ bezeichnet hierbei den Totalreflexionswinkel für die Grenzfläche zwischen Fenster und umgebenden Medium und ist gegeben durch

$$\alpha_t = \arcsin\,(n_0/n_F).$$

Diese Formgebung des Fensters besitzt den Vorteil, daß Strahlungsanteile, die an einer der beiden den Winkel $\beta$ einschließenden Begrenzungsflächen totalreflektiert werden, an der entsprechenden anderen Begrenzungsfläche ausgekoppelt werden. Fortlaufende, mehrfache Totalreflexionen werden so reduziert und die Strahlungsausbeute verbessert.

Weiterhin weist das Fenster mindestens eine relativ zur Mehrschichtstruktur schräg oder konkav verlaufende oder gestufte Seitenfläche auf, so daß sich das Fenster von der Mehrschichtstruktur aus gesehen mit wachsendem Abstand zur Mehrschichtstruktur verjüngt. Durch die schräge Anordnung der Seitenfläche zur Mehrschichtstruktur wird der Einfallswinkel für innerhalb der aktiven Schicht erzeugte Strahlung relativ zu der betreffenden Seitenfläche verringert und so die Auskopplung weiter erhöht.

Bei einer bevorzugten Ausführungsform der Erfindung ist die der Hauptfläche des Fensters gegenüberliegende Seite als Montagefläche des Chips vorgesehen. Dabei können beispielsweise die Seitenflächen des Fensters einen die Auskoppelbedingung erfüllenden Winkel β einschließen. Unter Seitenflächen sind dabei insbesondere die Fensterflanken, d.h. die von der Hauptfläche zur gegenüberliegenden Seite des Fensters verlaufenden Begrenzungsflächen des Fensters zu verstehen. Besonders bevorzugt sind bei dieser Ausführungsform Fenster mit einem zu der Hauptfläche parallelen Querschnitt, im folgenden als lateraler Querschnitt bezeichnet, der die Form eines Dreiecks mit den Innenwinkeln β, γ, und δ besitzt, wobei zumindest einer dieser Winkel die oben genannte Auskoppelbedingung erfüllt.

Die Strahlungsausbeute wird vorteilhafterweise weiter erhöht, wenn zwei oder sogar alle drei Innenwinkel die Auskoppelbedingung erfüllen. Besonders bevorzugt sind daher Fenster mit einem lateralen dreieckigen Querschnitt mit Innenwinkeln β, γ und δ, für die gilt

$$90° - \alpha_t < \beta < 2\,\alpha_t,$$

$$90° - \alpha_t < \gamma < 2\,\alpha_t,$$

$$90° - \alpha_t < \delta < 2\,\alpha_t.$$

Bei einem solchen Querschnitt ist für Strahlungsanteile, die in der Querschnittsebene propagieren, gewährleistet, daß jeder Strahlungsanteil nach maximal einer Totalreflexion beim Auftreffen auf die nächste Grenzfläche des Fensters zumindest teilweise ausgekoppelt wird.

Besonders bevorzugt ist eine Formgebung, bei der das Fenster eine relativ zur Mehrschichtstruktur schräg oder konkav verlaufende oder gestufte Seitenfläche aufweist, der von der Mehrschichtstruktur aus gesehen eine senkrecht zur Mehrschichtstruktur verlaufende Seitenfläche nachgeordnet ist und sich insbesondere an erstere anschließt.

Die senkrecht zur Mehrschichtstruktur angeordnete Seitenfläche erleichtert dabei die Herstellung und Montage des Fensters, während die schräge Seitenfläche vor allem die Strahlungsausbeute erhöht. Weitergehend können dazu Seitenflächen des Fensters, insbesondere schräg zur Mehrschichtstruktur angeordnete Seitenflächen, aufgerauht sein.

Als Montagefläche des Chips kann bei dieser Formgebung die der Hauptfläche gegenüberliegende, vorzugsweise zur Hauptfläche parallele Seite des Fensters dienen, mit der der strahlungsemittierende Chip in ein entsprechendes Gehäuse eingelötet oder eingeklebt sein kann.

Bevorzugt schließen bei dieser Form zwei Seitenflächen des Fenstersockels einen Winkel ein, der die Auskoppelbedingung erfüllt. Unter dem Fenstersockel ist dabei der Bereich des Fensters zu verstehen, der durch die senkrecht zur Mehrschichtstruktur angeordneten Seitenflächen begrenzt wird. Besonders bevorzugt ist hierbei wiederum eine Formgebung, bei der der Fenstersockel einen lateralen Querschnitt in Form eines Dreiecks aufweist, wobei mindestens ein Dreiecksinnenwinkel die Auskoppelbedingung erfüllt. Allgemein ist für den Fenstersockel eine Prismenform vorteilhaft, bei der möglichst viele Innenwinkel die Auskoppelbedingung erfüllen.

Vorzugsweise ist bei der Erfindung die Mehrschichtstruktur epitaktisch hergestellt und das Fenster aus einem zur Epitaxie verwendeten Substrat gefertigt. Damit wird vorteilhaft der zur Herstellung des Chips erforderliche Aufwand gering gehalten, da das Fenster zugleich als Epitaxiesubstrat dient.

Bei einer vorteilhaften Weiterbildung der Erfindung sind die Materialien für das Fenster und die Mehrschichtstruktur, insbesondere die darin enthaltene aktive Schicht, so gewählt, daß der Brechungsindex des Fensters größer ist als der Brechungsindex der Mehrschichtstruktur bzw. der darin enthaltenen aktiven Schicht. Der Übergang von der Mehrschichtstruktur in das Fenster stellt dann einen Übergang in ein optisch dichteres Medium dar, so daß an der Grenzfläche zwischen Mehrschichtstruktur und Fenster keine Totalreflexion der innerhalb der Mehrschichtstruktur erzeugten Strahlung auftritt.

Eine besonders bevorzugte Ausführungsform der Erfindung betrifft strahlungsemittierende Halbleiterchips auf GaN-Basis. Bei diesen Halbleiterchips enthält die Mehrschichtstruktur, insbesondere die aktive Schicht, GaN, AlGaN, InGaN oder InAlGaN. Die aktive Schicht kann dabei auch als Schichtenfolge, beispielsweise in Form einer Quantentopf-Struktur, ausgeführt sein. Derartige Mehrschichtstrukturen werden in der Regel epitaktisch hergestellt, wobei sich als Epitaxiesubstrat insbesondere SiC-Substrate oder Saphirsubstrate eignen.

Das Fenster wird vorzugsweise aus den verwendeten Epitaxiesubstraten gefertigt. Zur Erfüllung der Auskoppelbedingungen ist bei einem SiC-Substrat mit einem Brechungsindex von etwa 2,7 eine teilweise Umhüllung im Bereich der den Winkel $\beta$ einschließenden Begrenzungsflächen mit einem Brechungsindex $n_0$ größer 1,35 erforderlich, da die Auskoppelbedingung nur für ein Brechungsindexverhältnis $n_F/n_0 < 2$ erfüllbar ist. Dies wird im folgenden noch genauer erläutert.

Als Umhüllung können insbesondere Reaktionsharze, beispielsweise Epoxidharze, Acrylharze, Silikonharze oder eine Mischung dieser Harze dienen. Hierbei zeichnen sich Epoxidharze durch eine hohe Transparenz und Silikonharze durch eine besonders gute Strahlungsbeständigkeit, insbesondere im blaugrünen, blauen und ultravioletten Spektralbereich, aus.

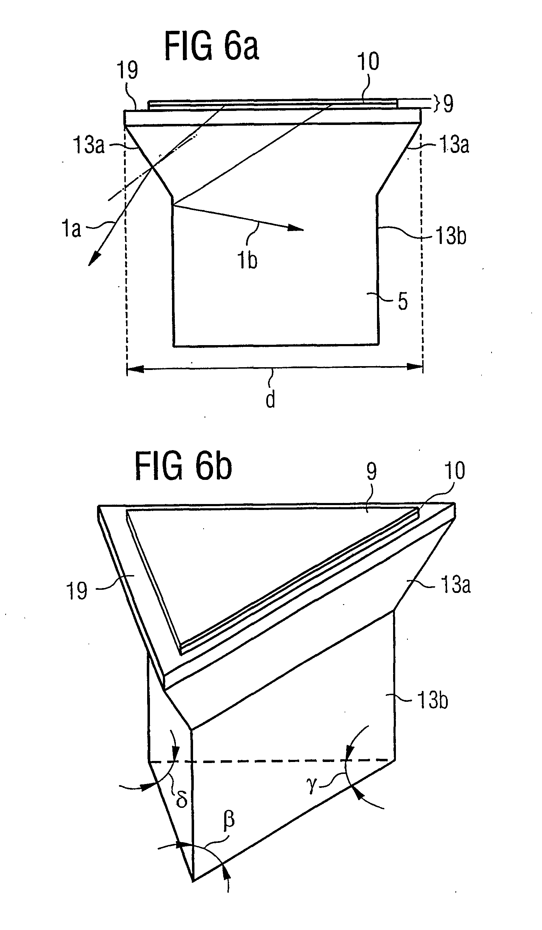

Weitere Merkmale, Vorzüge und Zweckmäßigkeiten der Erfindung werden nachfolgend anhand von einem Ausführungsbeispiel in Verbindung mit den Figuren 6 und 7 erläutert.

Figuren 1 bis 8 zeigen:

Figur 1a und 1b eine schematische Schnittdarstellung und eine Aufsicht eines Beispiels eines Bauelements,

Figur 2a und 2b jeweils eine schematische Teilschnittdarstellung eines ersten und eines zweiten Beispiels eines strahlungsemittierenden Chips,

Figur 3 eine schematische Schnittdarstellung eines dritten Beispiels eines strahlungsemittierenden Chips,

Figur 4 eine schematische perspektivische Darstellung eines vierten Beispiels eines strahlungsemittierenden Chips,

Figur 5a und 5b eine schematische perspektivische Darstellung und eine Schnittdarstellung eines fünften Beispieles eines strahlungsemittierenden Chips,

Figur 6a und 6b eine schematische Schnittdarstellung und eine perspektivische Darstellung des Ausführungsbeispieles des erfindungsgemäßen strahlungsemittierenden Chips,

Figur 7 eine schematische Darstellung des Auskoppelgrades des Ausführungsbeispieles des erfindungsgemäßen strahlungsemittierenden Chips im Vergleich zu einem strahlungsemittierenden Chip nach dem Stand der Technik und

Figur 8 eine schematische Schnittdarstellung eines strahlungsemittierenden Chips nach dem Stand der Technik.

Gleiche oder gleichwirkende Elemente sind in den Figuren mit denselben Bezugszeichen versehen.

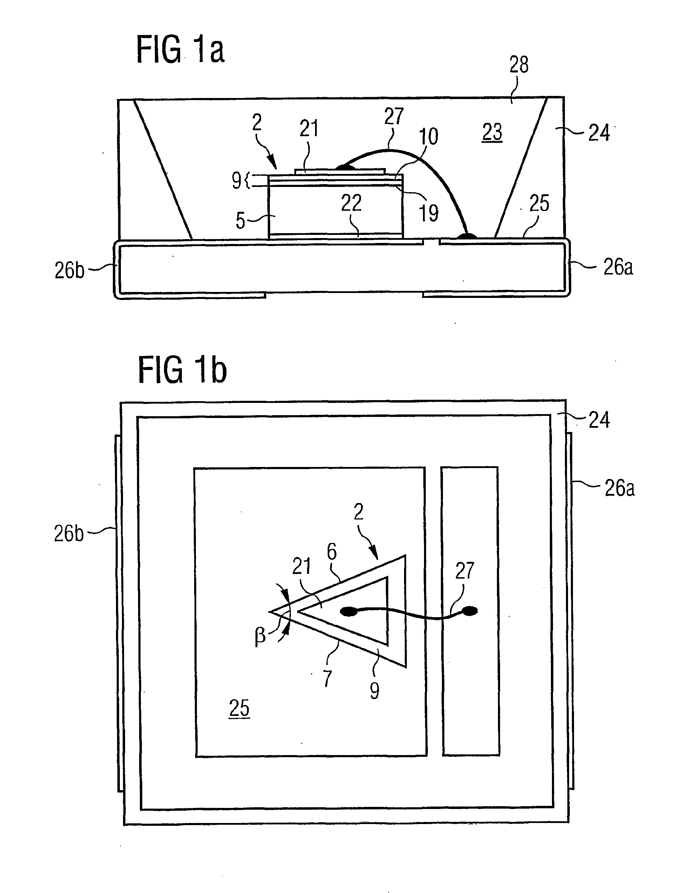

Das in Figur 1a im Schnitt und 1b in der Aufsicht dargestellte Bauelement umfaßt einen strahlungsemittierenden Chip 2, der in einer Ausnehmung 23 eines Gehäusegrundkörpers 24 angeordnet ist. Die Seitenwände der Ausnehmung sind angeschrägt und dienen als Reflektor für die von dem Chip 2 erzeugte Strahlung.

Der strahlungsemittierende Chip 2 weist ein Fenster 5 mit einer Hauptfläche 19 auf, auf der eine Mehrschichtstruktur 9 angeordnet ist. Die Schnittebene der in Figur 1a gezeigten Ansicht steht senkrecht auf der Hauptfläche 19.

Innerhalb der Mehrschichtstruktur 9 ist eine strahlungserzeugende aktive Schicht 10 ausgebildet. Auf der von dem Fenster 5 abgewandten Seite ist die Mehrschichtstruktur 9 mit einer oberen Kontaktfläche 21, das Fenster auf der der Hauptfläche 19 gegenüberliegenden Seite mit einer unteren Kontaktfläche 22 versehen.

In den Gehäusegrundkörper ist ein Leiterrahmen 25 eingebettet, wobei Leiterrahmenanschlüsse 26a, 26b seitlich aus dem Gehäusegrundkörper 24 herausgeführt sind. Der Chip 2 ist mit der unteren Kontaktfläche 22 auf einen Chipanschlußbereich des Leiterrahmens 25 montiert. Der Chip 2 kann beispielsweise aufgelötet oder mittels eines elektrisch leitfähigen Haftmittels aufgeklebt sein. Von der oberen Kontaktfläche 21 aus ist eine Drahtverbindung 27 zu einem Drahtanschlußbereich des Leiterrahmens geführt.

Die Ausnehmung 23 in dem Gehäusegrundkörper ist mit einer strahlungsdurchlässigen, den Chip 2 umhüllenden Formmasse 28 gefüllt. Dies kann beispielsweise ein Verguß auf der Basis eines Reaktionsharzes sein. Hierfür eignen sich insbesondere Epoxidharze, Acrylharze, Silikonharze oder Mischungen dieser Harze.

Weiterhin kann die den Chip 2 umhüllende Formmasse 28 Leuchtstoffe enthalten, die einen Teil der von dem Chip erzeugten Strahlung in Strahlung anderer Wellenlänge umwandelt. Die von dem Bauelement erzeugte Strahlung kann beispielsweise aufgrund additiver Farbmischung den optischen Eindruck mischfarbigen oder insbesondere weißen Lichts hervorrufen. Geeignete Leuchtstoffe sind zum Beispiel Leuchtstoffe mit der allgemeinen Formel $A_3B_5X_{12}$:M, wobei $A_3B_5X_{12}$ einen Wirtskristall und M ein darin eingebautes Leuchtzentrum, vorzugsweise ein Atom oder Ion aus der Gruppe der Seltenen Erden wie beispielsweise Ce, bezeichnet. Als effiziente Leuchtstoffe haben sich die Verbindungen YAG:Ce ($Y_3Al_5O_{12}$: Ce), TAG: Ce ($Tb_3Al_5O_{12}$: Ce), TbYAG:Ce (($Tb_xY_{1-x})_3Al_5O_{12}$:Ce, $0 \leq x \leq 1$), GdYAG:Ce (($Gd_xY_{1-x})_3Al_5O_{12}$:$Ce^{3+}$,

$0 \leq x \leq 1$) und GdTbYAG:Ce $((Gd_x Tb_y Y_{1-x-y})_3 Al_5 O_{12}: Ce^3, 0 \leq x \leq 1, 0 \leq y \leq 1)$ sowie hierauf basierende Gemische erwiesen. Dabei kann Al zumindest teilweise durch Ga oder In ersetzt sein.

Das Fenster 5 des Chips 2 kann beispielsweise aus einem SiC-Substrat gefertigt sein, auf dem die Mehrschichtstruktur 9 in Form einer GaN-basierenden Halbleiterschichtenfolge aufgewachsen ist.

Der Chip 2 weist einen lateralen Querschnitt in Form eines Dreiecks auf. Dabei schließen zwei Seitenflächen 6,7 des Fensters einen Innenwinkel $\beta$ des Dreiecks ein, der die Auskoppelbedingung erfüllt.

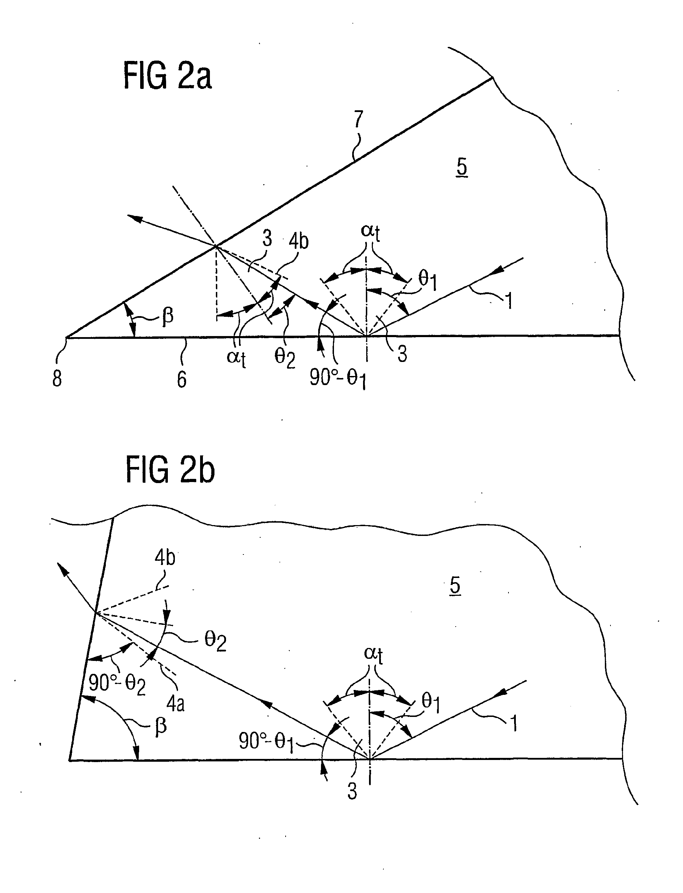

Die Auskoppelbedingung wird im folgenden anhand der Figuren 2a und 2b genauer erläutert. Figur 2a und 2b zeigen jeweils eine Teilschnittansicht eines Fensters 5 eines strahlungsemittierenden Chips. Das Fenster 5 weist eine erste Begrenzungsfläche 6 und eine zweite Begrenzungsfläche 7 auf, die auf der Schnittebene senkrecht stehen und einen Winkel $\beta$ einschließen, der die Auskoppelbedingung erfüllt. Dadurch ist gewährleistet, daß - ohne Beschränkung der Allgemeinheit - nach einer Totalreflexion an der ersten Begrenzungsfläche 6 die Strahlung an der zweiten Begrenzungsfläche 7 zumindest teilweise ausgekoppelt wird bzw. nicht ein zweites Mal totalreflektiert wird.

Man betrachtet dazu in Figur 2a den Strahl 1, der unter einem Einfallswinkel $\theta_1$ auf die erste Begrenzungsfläche 6 trifft, dort totalreflektiert wird und nachfolgend unter einem Winkel $\theta_2$ auf die Begrenzungsfläche 7 einfällt. Damit der Strahl 1 an der zweiten Begrenzungsfläche nicht ein zweites Mal totalreflektiert wird, muß der Einfallswinkel $\theta_2$ kleiner als der Totalreflexionswinkel $\alpha_t$ sein bzw. der Strahl innerhalb des Auskopplungskegels 3 auftreffen.

Der Winkel $\beta$ ist also einerseits so groß zu wählen, daß, wie in Figur 2a dargestellt, der Strahl 1 bezüglich der in Figur 2a rechtsseitigen Berandung 4b innerhalb Auskopplungskegels 3 auf die Grenzfläche 7 auftrifft, wobei gilt

$$\theta_2 < \alpha_t \qquad (1)$$

Andererseits ist $\beta$ so klein zu wählen, daß, wie in Figur 2b dargestellt, der Strahl 1 auch bezüglich der in Figur 2b linksseitigen Berandung 4a des Auskopplungskegels 3 auf die Grenzfläche auftrifft, wobei wiederum gilt

$$\theta_2 < \alpha_t \qquad (2)$$

Im ersten, in Figur 2a dargestellten Fall ergibt sich für den Zusammenhang von $\beta$, $\theta_1$ und $\theta_2$

$$\theta_2 = \theta_1 - \beta, \qquad (3)$$

so daß aus (1) folgt

$$\beta > \theta_1 - \alpha_t \qquad (4)$$

Da der Strahl 1 an der Begrenzungsfläche 6 total reflektiert wird, liegt $\theta_1$ zwischen 90° und $\alpha_t$. Die Bedingung (4) ist somit für alle möglichen Winkel $\theta_1$ erfüllt, wenn gilt

$$\beta > 90° - \alpha_t \qquad (5)$$

Für den in Figur 2b dargestellten zweiten Fall gilt zwischen $\theta_1$, $\theta_2$ und $\beta$ der Zusammenhang

$$\theta_2 = \beta - \theta_1 \qquad (6)$$

Aus (2) folgt damit

$$\beta < \alpha_t + \theta_1 \qquad (7)$$

Wiederum liegt aufgrund der ersten Totalreflexion an der Grenzfläche 6 der Winkel $\theta_1$ zwischen $\alpha_t$ und 90°, so daß (7) für alle möglichen Winkel $\theta_1$ erfüllt ist, wenn gilt

$$\beta < 2\alpha_t \qquad (8)$$

Aus der Kombination der durch (5) gegebenen Untergrenze für $\beta$ und der durch (8) gegebenen Obergrenze für $\beta$ folgt die Auskoppelbedingung

$$90° - \alpha_t < \beta < 2\alpha_t \qquad (9)$$

Der Totalreflexionswinkel $\alpha_t$ ist hierbei für ein Fenster 5 mit dem Brechungsindex $n_F$ und ein angrenzendes Medium mit einem bezüglich $n_F$ kleineren Brechungsindex $n_0$ gegeben durch

$$\alpha_t = \arcsin (n_0/n_F). \qquad (10)$$

Um die Auskoppelbedingung zu erfüllen, muß $\alpha_t$ größer als 30° sein. Ansonsten wäre die Untergrenze für $\beta$ größer als 60° und die Obergrenze für $\beta$ kleiner als 60°, so daß die beiden Ungleichungen der Auskoppelbedingung durch keinen Wert für $\beta$ gleichzeitig erfüllt sind.

Demnach muß das Brechungsindexverhältnis $n_0/n_F$ Gleichung (10) zufolge größer als 0,5 sein. Dem entspricht, daß der Brechungsindex $n_F$ des Fensters maximal doppelt so groß sein darf wie der Brechungsindex des angrenzenden Mediums $n_0$. Andernfalls ist die Auskoppelbedingung nicht erfüllbar.

Für hochbrechende Materialien wie beispielsweise SiC mit einem Brechungsindex von etwa $n_0 = 2,7$ kann dies durch ein den strahlungsemittierenden Chip umgebendes Medium in Form einer entsprechende Umhüllung, beispielsweise einer Vergußmasse mit einem Brechungsindex $n_0 > 1,35$, erreicht werden. Zum Beispiel beträgt für eine Vergußmasse mit einem typischen Brechungsindex von $n_0 = 1,5$ der Totalreflexionswinkel $\alpha_t$ etwa 34°. Aus der Auskoppelbedingung (9) ergibt sich damit für $\beta$ ein Bereich

$$56° < \beta < 68°.$$

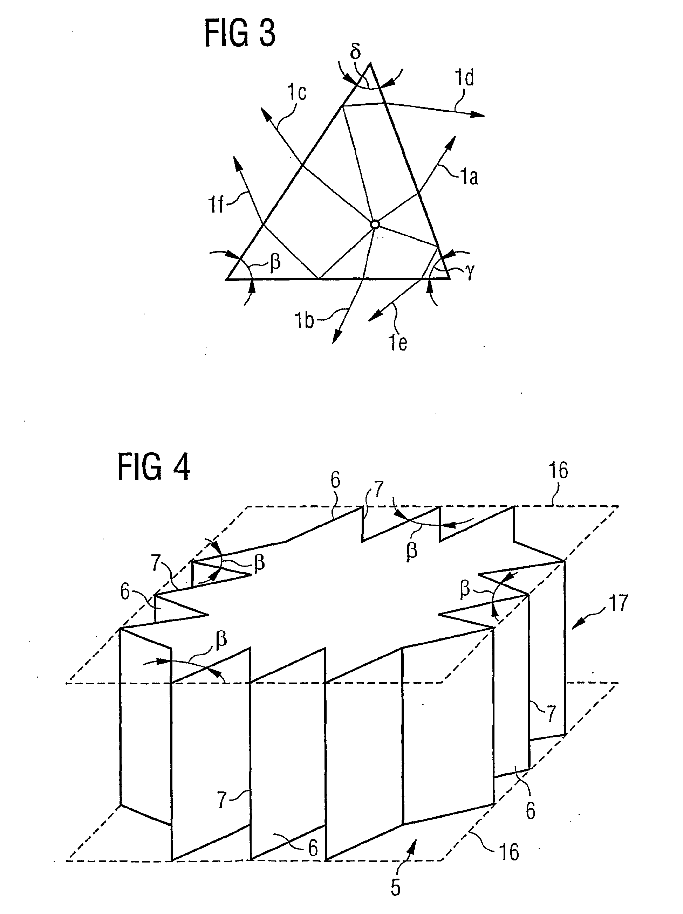

In Figur 3 ist der laterale Querschnitt einer besonders vorteilhaften Fensterform eines Chips dargestellt.

Der Querschnitt weist die Form eines Dreieckes auf, wobei für alle drei Innenwinkel $\beta$, $\gamma$ und $\delta$ die Auskoppelbedingung erfüllt ist. Für das oben genannte Beispiel eines SiC-Fensters mit einem Brechungsindex $n_F = 2,7$ und einem Verguß mit einem Brechungsindex $n_0 = 1,5$ wäre dies insbesondere auch für ein gleichseitiges Dreieck($\beta = \gamma = \delta = 60°$) der Fall. Mit großem Vorteil wird jeder innerhalb der Querschnittsebene verlaufende Strahl entweder direkt nach dem Auftreffen auf eine Seitenfläche ausgekoppelt, vgl. Strahlen 1a, 1b, 1c, oder maximal einmal totalreflektiert, vgl. Strahlen 1d, le, 1f. Ein fortgesetzter Umlauf unter mehrfacher Totalreflexion, wie er beispielsweise in Figur 8 dargestellt ist, kann nicht auftreten.

In Figur 4 ist perspektivisch ein Fenster 5 eines weiteren Beispiels eines strahlungsemittierenden Chips dargestellt. Im Unterschied zu dem zuvor beschriebenen Ausführungsbeispiel weist der laterale Querschnitt eine quadratische Einhüllende 16 auf. Umfangsseitig ist das Fenster mit einer gezackten Auskoppelstruktur 17 versehen, deren äußere Kanten von je zwei Flächen 6, 7 gebildet werden, die einen die Auskoppelbedingung erfüllenden Winkel $\beta$ einschließen. Bei der Herstellung eines solchen Fensters kann vorteilhafterweise ein herkömmliches Fenster mit quadratischem Querschnitt verwendet werden, das durch Abtragung der entsprechenden Bereiche, beispielsweise durch Einsägen oder Ätzen, mit der gezeigten zackenförmigen Auskoppelstruktur 17 versehen wird.

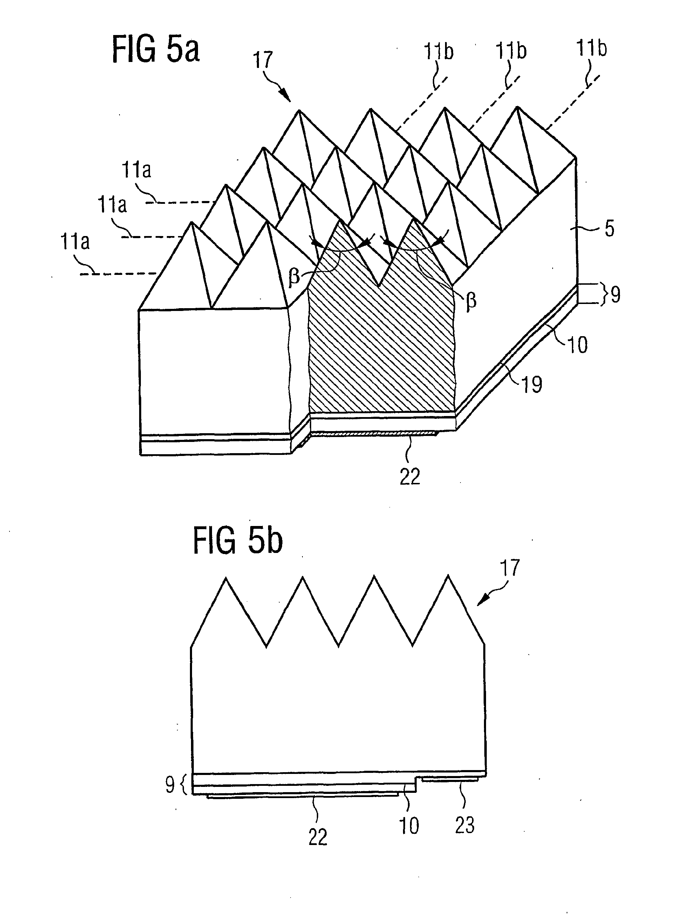

In Figur 5a ist perspektivisch ein weiteres Beispiel eines strahlungsemittierenden Chips dargestellt. Auf ein Fenster 5 ist hier eine Mehrschichtstruktur 9 mit einer strahlungsaktiven Schicht 10 aufgebracht, so daß die Mehrschichtstruktur 9 an eine Hauptfläche 19 des Fensters 5 grenzt. Parallel zu dieser Hauptfläche weist das Fenster einen quadratischen lateralen Querschnitt auf und ist auf der der Hauptfläche gegenüberliegenden Seite mit einer Auskoppelstruktur 17 versehen, die sich aus einer Mehrzahl von Pyramiden zusammen setzt. Der Winkel β zwischen zwei einander gegenüberliegenden Pyramidenseitenflächen ist dabei so gewählt, daß er die Auskoppelbedingung erfüllt.

Die dem Fenster 5 abgewandte Seite der Mehrschichtstruktur 9 ist mit einer Kontaktfläche 22 versehen, über die im Betrieb der Betriebsstrom in die strahlungsaktive Schicht eingeprägt wird. Die Kontaktfläche 22 dient zugleich als Montageseite des Chips. Beispielsweise kann der Chip wie bereits beschrieben mit dieser Kontaktfläche auf einer Chipmontagefläche eines geeigneten Gehäuses befestigt werden. Eine weitere Kontaktfläche (nicht dargestellt) kann zum Beispiel an den Seitenflächen des Fensters angebracht sein, sofern das Fenster elektrisch leitfähig ist.

In Figur 5b ist im Schnitt eine Abwandlung des Beispiels dargestellt. Hier sind auf der dem Fenster 5 abgewandten Seite der Mehrschichtstruktur 9 zwei Kontaktflächen 22 und 23 angeordnet. Ein Teil der Mehrschichtstruktur 9 einschließlich der aktiven Schicht 10 ist abgetragen und eine der beiden Kontaktflächen 23 auf dem an der Stelle der Abtragung verbleibenden Teil der Mehrschichtstruktur 9 angeordnet. Die andere Kontaktfläche 22 ist wie bei dem in Figur 5a gezeigten Chip auf der dem Fenster 5 gegenüberliegenden Hauptfläche der Mehrschichtstruktur 9 aufgebracht.

Bei dieser Anordnung ist der zwischen Fenster 5 und aktiver Schicht 10 liegende Bereich der Mehrschichtstruktur 9 mit der Kontaktfläche 23 verbunden, so daß ein über die Kontaktflächen 22 und 23 eingeprägter Betriebsstrom durch die aktive Schicht 10 fließt.

Vorteilhafterweise kann bei diesem Beispiel wie auch bei dem vorigen Beispiel bei der Herstellung des Fensters von einer herkömmlichen, würfelartigen oder quaderförmigen Fensterstruktur ausgegangen werden, so daß bestehende Herstellungsverfahren und -vorrichtungen teilweise weiter verwendet werden können. Die Auskoppelpyramiden können beispielsweise durch Ätzen oder Einsägen hergestellt werden. Im letzten Fall wird dazu ein V-förmiges Formsägeblatt verwendet und das Fenster auf der der Mehrschichtstruktur 9 gegenüberliegenden Seite entlang der zueinander orthogonalen Sägelinien 11a und 11b mehrfach parallel eingesägt.

In Figur 6a ist eine schematische Schnittdarstellung, in Figur 6b eine zugehörige perspektivische Darstellung eines besonders bevorzugten Ausführungsbeispieles eines erfindungsgemäßen strahlungsemittierenden Chips dargestellt. Der Chip weist wie das zuvor beschriebene Beispiel eine strahlungsaktive Schicht 10 umfassende Mehrschichtstruktur 9 auf, die an eine Hauptfläche 19 eines Fensters 5 grenzt. Die Schnittebene der in Figur 6a gezeigten Schnittdarstellung steht senkrecht auf der Mehrschichtstruktur bzw. der Hauptfläche des Fensters 5.

Im Unterschied zu den vorigen Beispielen weist das Fenster schräg zur Mehrschichtstruktur 9 verlaufende Seitenflächen 13a auf, die jeweils in senkrecht zur Mehrschichtstruktur angeordnete Seitenflächen 13b übergehen. Eine solche Fensterform kann beispielsweise durch Einsägen des Fensters 5 von der der Mehrschichtstruktur 9 abgewandten Seite her mit einem geeigneten Formsägeblatt hergestellt werden.

Durch die Schrägstellung der Seitenflächen 13a wird für die dort auftreffende Strahlung 1a der Einfallswinkel verringert und entsprechend der Anteil der ausgekoppelten Strahlung erhöht.

Hingegen werden Strahlungsanteile 1b, die auf die senkrecht zur Mehrschichtstruktur angeordneten Seitenflächen 13b, also im Bereich des Fenstersockel, auftreffen, leichter total reflektiert, so daß die Strahlungsauskopplung im Bereich des Fenstersockels geringer ist als in dem Bereich der schräggestellten Fensterseitenflächen 13a.

Hierbei ist es vorteilhaft, den Fenstersockel so zu formen, daß zumindest zwei seiner Begrenzungsflächen, vorzugsweise zwei Seitenflächen, einen Winkel β einschließen, der die Auskoppelbedingung erfüllt. Besonders vorteilhaft ist hierbei ein Fenstersockel in Form eines Dreiecksprismas, vgl. Figur 6b, wobei vorzugsweise zwei oder sogar alle drei Innenwinkel β, γ, und δ des lateralen dreieckigen Querschnitts des Fenstersockels die Auskoppelbedingung erfüllen.

Zwar wird bei dem gezeigten Ausführungsbeispiel durch die Auskoppelbedingung nicht in jedem Fall sichergestellt, daß nur maximal eine Totalreflexion auftritt, da die Strahlung nicht ausschließlich parallel zur Hauptebene des Fensters bzw. der Mehrschichtstruktur 9 propagiert, vgl. Strahl 1b. Dennoch wird für einen Teil dieser Strahlung eine fortlaufende, die Auskopplung behindernde Totalreflexion unterbunden und der Auskoppelgrad insgesamt erhöht.

Dies wird durch die in Figur 7 dargestellte Grafik belegt. Dargestellt ist der theoretisch berechnete Auskopplungsgrad k, d.h., die ausgekoppelte Strahlung bezogen auf die insgesamt erzeugte Strahlung für einen Figur 6a entsprechenden Chip mit verschiedenen Kantenlängen d. Die Linie 14 bzw. die zugehörigen Meßpunkte geben den Auskopplungsgrad für ein Fenster mit quadratischem Querschnitt, die Linie 15 und die zugehörigen Meßpunkte den Auskopplungsgrad für ein der Erfindung entsprechendes Fenster mit einem Querschnitt in Form eines gleichseitigen Dreieckes an. Der Auskoppelgrad wurde mittels eines Raytracing-Programms für ein SiC-Substrat und eine Umhüllung mit dem Brechungsindex $n_F$=2,7 bzw. $n_0$=1,55 ermittelt. Für diese Brechungsindices liegt ein Winkel von 60° in dem von der Auskoppelbedingung festgelegten Winkelbereich, so daß alle drei Innenwinkel eines gleichseitigen Dreiecks die Auskoppelbedingung erfüllen.

Eine Steigerung des Auskopplungsgrades bei der Erfindung wird für den gesamten dargestellten Kantenlängenbereich erreicht und beträgt teilweise über 25% (bezogen auf den Auskopplungsgrad des Fensters mit quadratischem Querschnitt). Somit wird mit der Erfindung auch für eine Figur 6a entsprechende Fensterform eine deutliche Verbesserung der Strahlungsauskoppelung erzielt.

Die Erläuterung der Erfindung anhand des gezeigten Ausführungsbeispieles stellt selbstverständlich keine Beschränkung der Erfindung hierauf dar.

**Patentansprüche**

1.  Strahlungsemittierender Halbleiterchip (2) mit einem strahlungsdurchlässigen Fenster (5), das einen Brechungsindex $n_F$ besitzt und eine Hauptfläche (19) aufweist, und
    einer Mehrschichtstruktur aus Halbleiterschichten (9), die eine strahlungserzeugende aktive Schicht (10) enthält und an der Hauptfläche (19) des Fensters (5) angeordnet ist,
    wobei das Fenster (5) von einem strahlungsdurchlässigen Medium mit einem Brechungsindex $n_0$, der kleiner ist als der Brechungsindex $n_F$ Fensters, umgeben ist, wobei $n_F/n_0 < 2$ gilt, und das Fenster (5) zu dem strahlungsdurchlässigen Medium hin mindestens von zwei Flächen (13b) begrenzt wird, die einen Winkel $\beta$ einschließen, für den die Beziehung

$$90° - \alpha_t < \beta < 2\, \alpha_t$$

    erfüllt ist, wobei $\alpha_t$ gegeben ist durch $\alpha_t = \arcsin(n_0/n_F)$, **dadurch gekennzeichnet, daß**
    das Fenster (5) mindestens eine Seitenfläche (13a) aufweist, die relativ zur Mehrschichtstruktur (9) derart schräg oder gekrümmt verläuft oder gestuft ist, daß sich das Fenster (5) von der Mehrschichtstruktur (9) aus gesehen verjüngt.

2.  Strahlungsemittierender Halbleiterchip (2) nach Anspruch 1,
    **dadurch gekennzeichnet, daß**
    die zwei Flächen (13b) Seitenflächen des Fensters (5) sind.

3.  Strahlungsemittierender Halbleiterchip (2) nach Anspruch 2,
    **dadurch gekennzeichnet, daß**
    die Seitenflächen (13b) senkrecht zur Mehrschichtstruktur (9) angeordnet sind und von der Mehrschichtstruktur aus gesehen der schräg oder gekrümmt verlaufenden oder gestuft gebildeten Seitenfläche (13a) nachgeordnet sind und sich insbesondere an diese anschließen.

4.  Strahlungsemittierender Halbleiterchip (2) nach einem der Ansprüche 1 bis 3,
    **dadurch gekennzeichnet, daß**
    das Fenster (5) parallel zu der Hauptfläche (19) einen dreieckigen Querschnitt mit den Innenwinkeln $\beta$, $\gamma$ und $\delta$ aufweist.

5.  Strahlungsemittierender Halbleiterchip (2) nach Anspruch 4,
    **dadurch gekennzeichnet, daß**
    für $\gamma$ die Beziehung

$$90° - \alpha_t < \gamma < 2\, \alpha_t$$

    erfüllt ist.

6.  Strahlungsemittierender Halbleiterchip (2) nach Anspruch 5,
    **dadurch gekennzeichnet, daß**
    für $\delta$ die Beziehung

$$90° - \alpha_t < \delta < 2\, \alpha_t$$

    erfüllt ist.

**7.** Strahlungsemittierender Halbleiterchip (2) nach einem der Ansprüche 3 bis 6,
**dadurch gekennzeichnet, daß**
das Fenster (5) im Bereich der senkrecht zur Mehrschichtstruktur (9) verlaufenden Seitenflächen (13b) die Form eines Prismas aufweist.

**8.** Strahlungsemittierender Halbleiterchip (2) nach einem der Ansprüche 1 bis 7,
**dadurch gekennzeichnet, daß**
zumindest die schräg oder konkav verlaufende oder gestufte Seitenfläche (13a) aufgerauht ist.

**9.** Strahlungsemittierender Halbleiterchip (2) nach einem der Ansprüche 1 bis 8,
**dadurch gekennzeichnet, daß**
die Mehrschichtstruktur (9) epitaktisch hergestellt ist und das Fenster (5) aus einem zur Epitaxie verwendeten Substrat gefertigt ist.

**10.** Strahlungsemittierender Halbleiterchip (2) nach einem der Ansprüche 1 bis 9,
**dadurch gekennzeichnet, daß**
der Brechungsindex $n_F$ des Fensters (5) größer als der Brechungsindex der Mehrschichtstruktur (9), insbesondere der aktiven Schicht (10) ist.

**11.** Strahlungsemittierender Halbleiterchip (2) nach einem der Ansprüche 1 bis 10,
**dadurch gekennzeichnet, daß**
die der Mehrschichtstruktur (9) gegenüberliegende Seite des Fensters (5) eine Montageseite des Halbleiterchips (2) ist.

**12.** Strahlungsemittierender Halbleiterchip (2) nach einem der Ansprüche 1 bis 11,
**dadurch gekennzeichnet, daß**
die Mehrschichtstruktur (9) mindestens eine der Verbindungen GaN, AlGaN, InGaN oder AllnGaN enthält.

**13.** Strahlungsemittierender Halbleiterchip (2) nach einem der Ansprüche 1 bis 12,
**dadurch gekennzeichnet, daß**
das Fenster (5) SiC enthält.

**14.** Strahlungsemittierender Halbleiterchip (2) nach einem der Ansprüche 1 bis 12,
**dadurch gekennzeichnet, daß**
das Fenster (5) Saphir enthält.

**15.** Strahlungsemitierendes Bauelement,
**dadurch gekennzeichnet, daß**
es einen strahlungsemittierenden Halbleiterchip (2) nach einem der Ansprüche 1 bis 14 enthält.

**16.** Strahlungsemittierendes Bauelement nach Anspruch 15,
**dadurch gekennzeichnet, daß**
es einen Gehäusegrundkörper (24) aufweist, auf den der strahlungsemittierende Halbleiterchip (2) montiert ist.

**17.** Strahlungsemittierendes Bauelement nach Anspruch 16,
**dadurch gekennzeichnet, daß**
in dem Gehäusegrundkörper (24) eine Ausnehmung (23) gebildet ist, in der der strahlungsemittierende Halbleiterchip (2) angeordnet ist.

**18.** Strahlungsemittierendes Bauelement nach Anspruch 17,
**dadurch gekennzeichnet, daß**
die Ausnehmung (23) mit dem den Halbleiterchip (2) bzw. das Fenster (5) umgebenden Medium gefüllt ist.

**19.** Strahlungsemittierendes Bauelement nach Anspruch 18,
**dadurch gekennzeichnet, daß**
die Ausnehmung (23) mit einem Reaktionsharz gefüllt ist.

**20.** Strahlungsemittierendes Bauelement nach Anspruch 19,

**dadurch gekennzeichnet, daß**

das Reaktionsharz ein Epoxidharz, ein Silikonharz, ein Acrylharz oder eine Mischung dieser Harze enthält.

**Claims**

1. Radiation-emitting semiconductor chip (2) with a radiation-transmissive window (5), which has a refractive index $n_F$ and a main area (19), and with a multilayer structure composed of semiconductor layers (9), which contains a radiation-generating active layer (10) and is arranged at the main area (19) of the window (5),

   the window (5) being surrounded by a radiation-transmissive medium having a refractive index no, which is less than the refractive index $n_F$ of the window, where $n_F/n_0 < 2$ holds true, and the window (5) is bounded toward the radiation-transmissive medium at least by two areas (13b), which form an angle $\beta$, for which the relationship

$$90° - \alpha_t < \beta < 2 \ \alpha_t$$

   is satisfied, where $\alpha_t$ is given by $\alpha_t = \arcsin(n_0/n_F)$,
   **characterized in that**
   the window (5) has at least one side area (13a), which, relative to the multilayer structure (9), runs obliquely or in curved fashion or is stepped in such a way that the window (5) tapers as seen from the multilayer structure (9).

2. Radiation-emitting semiconductor chip (2) according to Claim 1,
   **characterized in that**
   the two areas (13b) are side areas of the window (5).

3. Radiation-emitting semiconductor chip (2) according to Claim 2,
   **characterized in that**
   the side areas (13b) are arranged perpendicular to the multilayer structure (9) and, as seen from the multilayer structure, are arranged downstream of the side area (13a) which runs obliquely or in curved fashion or is formed in stepped fashion, and in particular adjoin said side area.

4. Radiation-emitting semiconductor chip (2) according to one of Claims 1 to 3,
   **characterized in that**
   the window (5), parallel to the main area (19), has a triangular cross section with the internal angles $\beta$, $\gamma$ and $\delta$.

5. Radiation-emitting semiconductor chip (2) according to Claim 4,
   **characterized in that**
   the relationship

$$90° - \alpha_t < \gamma < 2 \ \alpha_t$$

   is satisfied for $\gamma$.

6. Radiation-emitting semiconductor chip (2) according to Claim 5,
   **characterized in that**
   the relationship

$$90° - \alpha_t < \delta < 2 \ \alpha_t$$

   is satisfied for $\delta$.

7. Radiation-emitting semiconductor chip (2) according to one of Claims 3 to 6,
   **characterized in that**

the window (5) has the form of a prism in the region of the side areas (13b) running perpendicularly to the multilayer structure (9).

8. Radiation-emitting semiconductor chip (2) according to one of Claims 1 to 7,
   **characterized in that**
   at least the side area (13a) which runs obliquely or concavely or is stepped is roughened.

9. Radiation-emitting semiconductor chip (2) according to one of Claims 1 to 8,
   **characterized in that**
   the multilayer structure (9) is fabricated epitaxially and the window (5) is produced from a substrate used for the epitaxy.

10. Radiation-emitting semiconductor chip (2) according to one of Claims 1 to 9,
    **characterized in that**
    the refractive index $n_F$ of the window (5) is greater than the refractive index of the multilayer structure (9), in particular of the active layer (10).

11. Radiation-emitting semiconductor chip (2) according to one of Claims 1 to 10,
    **characterized in that**
    that side of the window (5) which is opposite to the multilayer structure (9) is a mounting side of the semiconductor chip (2).

12. Radiation-emitting semiconductor chip (2) according to one of Claims 1 to 11,
    **characterized in that**
    the multilayer structure (9) contains at least one of the compounds GaN, AlGaN, InGaN or AlInGaN.

13. Radiation-emitting semiconductor chip (2) according to one of Claims 1 to 12,
    **characterized in that**
    the window (5) contains SiC.

14. Radiation-emitting semiconductor chip (2) according to one of Claims 1 to 12,
    **characterized in that**
    the window (5) contains sapphire.

15. Radiation-emitting component,
    **characterized in that**
    it contains a radiation-emitting semiconductor chip (2) according to one of Claims 1 to 14.

16. Radiation-emitting component according to Claim 15,

    **characterized in that**
    it has a housing basic body (24), onto which the radiation-emitting semiconductor chip (2) is mounted.

17. Radiation-emitting component according to Claim 16,
    **characterized in that**
    a recess (23) is formed in the housing basic body (24), the radiation-emitting semiconductor chip (2) is arranged in said recess.

18. Radiation-emitting component according to Claim 17,
    **characterized in that**
    the recess (23) is filled with the medium surrounding the semiconductor chip (2) or the window (5).

19. Radiation-emitting component according to Claim 18,
    **characterized in that**
    the recess (23) is filled with a reaction resin.

20. Radiation-emitting component according to Claim 19,
    **characterized in that**

the reaction resin contains an epoxy resin, a silicone resin, an acrylic resin or a mixture of these resins.

**Revendications**

1. Puce en semiconducteur (2) émettrice de rayonnement comprenant une fenêtre (5) transparente au rayonnement, laquelle possède un indice de réfraction $n_F$ et présente une surface principale (19), et une structure multicouche composée de couches en semiconducteur (9), laquelle contient une couche active (10) génératrice de rayonnement et est disposée sur la surface principale (19) de la fenêtre (5), la fenêtre (5) étant entourée par un milieu transparent au rayonnement ayant un indice de réfraction $n_0$ qui est inférieur à l'indice de réfraction $n_F$ de la fenêtre, $n_F/n_0$ étant inférieur à 2, et la fenêtre (5) étant délimitée vers le milieu transparent au rayonnement par au moins deux surfaces (13b) qui forment un angle ß pour lequel la relation

$$90° - \alpha_t < ß < 2\alpha_t$$

est vérifiée, où $\alpha_t$ est défini par $\alpha_t$ = arcsin $(n_0/n_F)$,
**caractérisée en ce que**
la fenêtre (5) présente au moins une surface latérale (13a) qui s'étend en biais ou de manière curviligne par rapport à la structure multicouche (9) ou qui est étagée, de telle sorte que la fenêtre (5), vue depuis la structure multicouche (9), se rétrécit.

2. Puce en semiconducteur (2) émettrice de rayonnement selon la revendication 1, **caractérisée en ce que** les deux surfaces (13b) sont des surfaces latérales de la fenêtre (5).

3. Puce en semiconducteur (2) émettrice de rayonnement selon la revendication 2, **caractérisée en ce que** les surfaces latérales (13b) sont disposées perpendiculairement à la structure multicouche (9) et, vues depuis la structure multicouche, sont disposées après la surface latérale (13a) qui s'étend en biais ou de manière curviligne ou qui est de configuration étagée et sont notamment rattachées à celle-ci.

4. Puce en semiconducteur (2) émettrice de rayonnement selon l'une des revendications 1 à 3, **caractérisée en ce que** la fenêtre (5) présente, parallèlement à la surface principale (19), une section transversale triangulaire avec les angles internes ß, $\gamma$ et $\delta$.

5. Puce en semiconducteur (2) émettrice de rayonnement selon la revendication 4, **caractérisée en ce que** la relation

$$90° - \alpha_t < \gamma < 2\alpha_t$$

est vérifiée pour $\gamma$.

6. Puce en semiconducteur (2) émettrice de rayonnement selon la revendication 5, **caractérisée en ce que** la relation

$$90° - \alpha_t < \delta < 2\alpha_t$$

est vérifiée pour 8.

7. Puce en semiconducteur (2) émettrice de rayonnement selon l'une des revendications 3 à 6, **caractérisée en ce que** la fenêtre (5) présente la forme d'un prisme dans la zone des surfaces latérales (13b) qui s'étendent perpendiculairement à la structure multicouche (9).

8. Puce en semiconducteur (2) émettrice de rayonnement selon l'une des revendications 1 à 7, **caractérisée en ce qu'**au moins la surface latérale (13a) qui s'étend en biais ou de manière concave ou qui est de configuration étagée est brossée.

9. Puce en semiconducteur (2) émettrice de rayonnement selon l'une des revendications 1 à 8, **caractérisée en ce**

**que** la structure multicouche (9) est fabriquée par épitaxie et la fenêtre (5) est produite à partir d'un substrat utilisé pour l'épitaxie.

10. Puce en semiconducteur (2) émettrice de rayonnement selon l'une des revendications 1 à 9, **caractérisée en ce que** l'indice de réfraction $n_F$ de la fenêtre (5) est supérieur à l'indice de réfraction de la structure multicouche (9), notamment de la couche active (10).

11. Puce en semiconducteur (2) émettrice de rayonnement selon l'une des revendications 1 à 10, **caractérisée en ce que** le côté de la fenêtre (5) qui est à l'opposé de la structure multicouche (9) est un côté de montage de la puce en semiconducteur (2).

12. Puce en semiconducteur (2) émettrice de rayonnement selon l'une des revendications 1 à 11, **caractérisée en ce que** la structure multicouche (9) contient au moins l'un des composés GaN, AlGaN, InGaN ou AlInGaN.

13. Puce en semiconducteur (2) émettrice de rayonnement selon l'une des revendications 1 à 12, **caractérisée en ce que** la fenêtre (5) contient du SiC.

14. Puce en semiconducteur (2) émettrice de rayonnement selon l'une des revendications 1 à 12, **caractérisée en ce que** la fenêtre (5) contient du saphir.

15. Composant émetteur de rayonnement, **caractérisé en ce qu'**il contient une puce en semiconducteur (2) émettrice de rayonnement selon l'une des revendications 1 à 14.

16. Composant émetteur de rayonnement selon la revendication 15, **caractérisé en ce qu'**il présente un corps de base de boîtier (24) sur lequel est montée la puce en semiconducteur (2) émettrice de rayonnement.

17. Composant émetteur de rayonnement selon la revendication 16, **caractérisé en ce que** dans le corps de base de boîtier (24) est formée une cavité (23) dans laquelle est disposée la puce en semiconducteur (2) émettrice de rayonnement.

18. Composant émetteur de rayonnement selon la revendication 17, **caractérisé en ce que** la cavité (23) est remplie avec le milieu qui entoure la puce en semiconducteur (2) ou la fenêtre (5).

19. Composant émetteur de rayonnement selon la revendication 18, **caractérisé en ce que** la cavité (23) est remplie avec une résine de réaction.

20. Composant émetteur de rayonnement selon la revendication 19, **caractérisé en ce que** la résine de réaction contient une résine d'époxy, une résine de silicone, une résine acrylique ou un mélange de ces résines.

## FIG 1a

## FIG 1b

## FIG 2a

## FIG 2b

FIG 3

FIG 4

## FIG 5a

## FIG 5b

## FIG 6a

## FIG 6b

## FIG 7

## FIG 8

## IN DER BESCHREIBUNG AUFGEFÜHRTE DOKUMENTE

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- JP 10326910 A
- EP 0961328 A2
- JP 8288577 A